(19) Europäisches Patentamt / European Patent Office / Office européen des brevets

(11) **EP 2 286 294 B1**

(12) **FASCICULE DE BREVET EUROPEEN**

(45) Date de publication et mention de la délivrance du brevet:
**28.12.2016 Bulletin 2016/52**

(21) Numéro de dépôt: **09772697.0**

(22) Date de dépôt: **04.06.2009**

(51) Int Cl.:
*G02B 17/06* (2006.01)      *G21K 1/06* (2006.01)
*G02B 19/00* (2006.01)

(86) Numéro de dépôt international:
**PCT/FR2009/051058**

(87) Numéro de publication internationale:
**WO 2010/001015 (07.01.2010 Gazette 2010/01)**

(54) **COLLECTEUR DE RAYONNEMENT**

STRAHLUNGSKOLLEKTOR

RADIATION COLLECTOR

(84) Etats contractants désignés:
**AT BE BG CH CY CZ DE DK EE ES FI FR GB GR HR HU IE IS IT LI LT LU LV MC MK MT NL NO PL PT RO SE SI SK TR**

(30) Priorité: **05.06.2008 FR 0853731**

(43) Date de publication de la demande:
**23.02.2011 Bulletin 2011/08**

(73) Titulaire: **Safran Electronics & Defense**
**92100 Boulogne-Billancourt (FR)**

(72) Inventeurs:
• **MERCIER-YTHIER, Renaud**
**F-75015 Paris (FR)**
• **GEYL, Roland**
**F-94240 L'hay Les Roses (FR)**

(74) Mandataire: **Cabinet Plasseraud**
**66, rue de la Chaussée d'Antin**
**75440 Paris Cedex 09 (FR)**

(56) Documents cités:
**WO-A-01/02842        WO-A-2006/021419**
**WO-A-2008/052002     FR-A- 2 579 752**
**US-A- 2 198 014       US-A- 2 819 404**

• **SAKAYANAGI Y: "BRAGG OPTICS OF A LOGARITHMIC SPIRAL SURFACE" JAPANESE JOURNAL OF APPLIED PHYSICS, JAPAN SOCIETY OF APPLIED PHYSICS, TOKYO, JP, vol. V 21, no. N 3, 2 avril 1982 (1982-04-02), pages 225-226, XP009108945 ISSN: 0021-4922**

**Description**

La présente invention concerne un collecteur de rayonnement, et en particulier un tel collecteur qui est adapté pour collecter un rayonnement ayant une longueur d'onde d'environ 13,5 nm (nanomètre).

Pour obtenir des circuits électroniques avec un niveau d'intégration supérieur à ceux qui sont actuellement réalisés, il est envisagé d'utiliser des techniques lithographiques qui sont basées sur des rayonnements à très courte longueur d'onde, dits ultraviolets extrêmes ou EUV pour Extreme UV. Typiquement, la longueur d'onde EUV qui est considérée dans la suite est 13,5 nm.

Parmi les sources de tels rayonnements qui sont développées, celles du type à plasma produit par décharge, ou DPP pour «Discharge Produced Plasma» en anglais, présentent un rendement énergétique qui est supérieur et un encombrement qui est inférieur. Mais leur mise en oeuvre rencontre plusieurs difficultés, parmi lesquelles on peut citer :

- le rayonnement EUV est émis par la source dans un angle solide qui est trop large pour être utilisé directement, de sorte qu'il est nécessaire de concentrer une partie de ce rayonnement dans une tache («spot» en anglais) et dans un angle solide qui sont adaptés à l'utilisation de ce rayonnement ;

- le rayonnement EUV n'est produit qu'en direction d'un demi-espace antérieur qui est situé devant la source DPP, et le demi-espace postérieur est occupé par des composants de la source elle-même ;

- un système de protection, appelé «Mitigation Device» en anglais, est nécessaire entre la source DPP et un appareil d'utilisation du rayonnement, pour protéger ce dernier par rapport à des débris de matière qui sont expulsés par la source DPP.

Pour ces raisons, il est nécessaire d'utiliser un collecteur du rayonnement EUV qui est produit par une source DPP, et que ce collecteur soit disposé entre le système de protection et l'appareil d'utilisation du rayonnement EUV. Les caractéristiques suivantes sont alors recherchées pour un tel collecteur :

- une proportion du rayonnement qui est collecté, par rapport au rayonnement total qui est produit par la source, la plus grande possible ;
- une répartition du rayonnement dans la tâche de concentration produite par le collecteur, qui soit suffisamment uniforme ;
- des dimensions de la tache de concentration du rayonnement, et une ouverture angulaire du faisceau qui la forme, qui soient compatibles avec l'appareil d'utilisation du rayonnement EUV ;
- un placement du collecteur entre la source du rayonnement et l'appareil d'utilisation du rayonnement ;
- une forme et des dimensions d'ouverture pour l'entrée du rayonnement dans le collecteur, qui soient compatibles avec la disposition du système de protection entre la source DPP et le collecteur ;
- un encombrement du collecteur lui-même qui soit compatible avec une installation du collecteur sur des modules existants d'une ligne de production de circuits électroniques intégrés ;
- des formes des miroirs du collecteur qui soient compatibles avec les procédés existants de fabrication de miroirs, notamment les procédés d'usinage des surfaces de miroirs et les procédés de dépôt de couches réfléchissantes sur ces surfaces ; et
- un prix de revient unitaire du collecteur qui est réduit, notamment par rapport aux collecteurs à plusieurs coquilles concentriques qui sont disponibles actuellement, par exemple à huit coquilles.

Un but de la présente invention consiste donc à proposer un collecteur de rayonnement qui correspond aux caractéristiques précédentes, d'une façon améliorée par rapport aux collecteurs existants tels que décrits dans les documents US2819404 ou FR2579752.

Pour cela, l'invention propose un collecteur de rayonnement qui est adapté pour collecter une partie d'un rayonnement produit par une source, et pour concentrer cette partie collectée de rayonnement dans une tache formée par un faisceau de sortie convergent produit par le collecteur. Le collecteur comprend un miroir primaire et un miroir secondaire, chacun à symétrie de révolution autour d'un axe optique du collecteur, et qui sont disposés pour réfléchir la partie collectée du rayonnement d'abord par le miroir primaire puis par le miroir secondaire.

Le miroir primaire est concave et a une première génératrice, dans un plan méridien du dispositif contenant l'axe optique du collecteur, qui est située dans la bande [0,8 x R($\alpha$) ; 1,2 x R($\alpha$)], où R et $\alpha$ sont des coordonnées polaires à l'intérieur du plan méridien, R étant une coordonnée radiale mesurée à partir d'un point de l'axe optique auquel la source du rayonnement est destinée à être placée et $\alpha$ étant une coordonnée angulaire mesurée à partir de l'axe optique, et R($\alpha$) étant calculée selon l'équation (1) suivante :

$$R(\alpha) = R_0 \cdot exp\left[-\alpha \cdot tan(i)\right] \qquad (1)$$

Dans cette équation, $\alpha$ est exprimée en radians, $R_0$ est une longueur constante, et i est un angle constant différent de +/-90° (degré).

Le miroir secondaire a une seconde génératrice dans le plan méridien, qui est adaptée pour que ce miroir secondaire produise le faisceau de sortie convergent d'un côté du collecteur opposé à la source du rayonnement, à partir de la partie collectée du rayonnement qui est réfléchie par le miroir primaire.

La seconde génératrice du miroir secondaire à l'intérieur du plan méridien est constituée de points qui sont situés dans le domaine [0,8 x X($\alpha$) ; 1,2 x X($\alpha$)] x [0,8 x Y($\alpha$) ; 1,2 x Y($\alpha$)], X et Y étant des coordonnées cartésiennes ayant pour origine le point de placement de la source du rayonnement et X correspondant à l'axe optique du collecteur, X($\alpha$) et Y($\alpha$) étant calculées selon les équations (2) et (3) suivantes :

$$X(\alpha) = \frac{2 \cdot R(\alpha) \cdot cos(\alpha) \cdot \left[L - R(\alpha) \cdot (1 + cos(2i))\right] + (f^2 - L^2 + 2 \cdot L \cdot R(\alpha)) \cdot cos(\alpha)}{2\left[L - R(\alpha) \cdot (1 + cos(2i)) + f \cdot cos(\alpha)\right]} \qquad (2)$$

$$Y(\alpha) = R(\alpha) \cdot sin(\alpha) + \left[X(\alpha) - R(\alpha) \cdot cos(\alpha)\right] \cdot tan(\alpha + 2 \cdot i) \qquad (3)$$

Dans ces équations :

$\alpha$ est la coordonnée polaire angulaire de l'équation (1), qui est utilisée pour paramétrer les coordonnées cartésiennes de la seconde génératrice,

R($\alpha$) est calculée selon l'équation (1),

f est la distance entre le point de placement de la source du rayonnement et la tache de concentration de la partie collectée du rayonnement, mesurée le long de l'axe optique, et

L est la longueur d'un chemin optique entre le point de placement de la source du rayonnement et la tache de concentration de la partie collectée du rayonnement, mesurée le long d'un rayon qui est issu de la source du rayonnement et réfléchi par le miroir primaire puis par le miroir secondaire.

Ainsi, un collecteur selon l'invention ne comprend que deux miroirs. Il est donc moins complexe et moins onéreux que des collecteurs connus qui ont plus de miroirs.

De plus, tout le rayonnement qui est collecté est réfléchi par le miroir primaire puis par le miroir secondaire, qui sont chacun continus. De cette façon, le rayonnement collecté n'est pas divisé en fonction d'une pluralité de miroirs séparés opérant en parallèle et ayant des rôles identiques. Pour cette raison, le rayonnement collecté est réparti plus uniformément dans la tâche de concentration qui est produite par le collecteur.

Le faisceau de sortie qui contient le rayonnement collecté est produit par le collecteur vers un côté qui est opposé à celui de la source. Autrement dit, le rayonnement qui est collecté traverse le collecteur. De cette façon, le collecteur peut être disposé facilement entre la source du rayonnement et un appareil d'utilisation de ce rayonnement, selon un alignement parallèle à l'axe optique du collecteur.

Pour la même raison, un collecteur selon l'invention est particulièrement adapté pour une source du rayonnement dont la partie postérieure, du côté opposé au rayonnement produit, n'est pas libre d'encombrement.

De plus, pour un collecteur selon l'invention, la source du rayonnement est destinée à être placée à distance du collecteur, notamment du miroir primaire de celui-ci. Ainsi, un système de protection peut être intercalé entre la source du rayonnement et le collecteur.

Pour ces raisons, un collecteur qui est conforme à l'invention est particulièrement adapté pour être associé à une source de rayonnement EUV du type DPP. Pour une telle utilisation du collecteur notamment, les miroirs primaire et secondaire peuvent être adaptés pour réfléchir un rayonnement EUV, notamment un rayonnement de longueur d'onde 13,5 nm.

Simultanément, un collecteur selon l'invention peut être agencé facilement par rapport à un appareil d'utilisation du rayonnement, de sorte que la tache de concentration du rayonnement collecté soit située au niveau d'une entrée optique de l'appareil d'utilisation du rayonnement.

Dans l'équation (1) de la génératrice du miroir primaire, i est un paramètre du collecteur qui correspond à l'angle d'incidence du rayonnement de la source sur ce miroir, lorsque la source est placée convenablement à l'entrée du collecteur. Dans toute la description qui suit, l'angle d'incidence d'un rayon qui est réfléchi par un miroir quelconque est mesuré par rapport à une direction perpendiculaire à la surface de ce miroir au point de réflexion du rayon. L'angle d'incidence d'un rayon qui est issu de la source est donc constant sur le miroir primaire, quelque soit le point de réflexion sur ce miroir. Les avantages suivants résultent de cette propriété du miroir primaire :

- le miroir primaire peut être optimisé pour cette valeur précise de l'angle d'incidence, par exemple en étant recouvert d'un ensemble de couches approprié ;

- les conditions de réflexion du rayonnement collecté sont identiques en tous les points du miroir primaire, ce qui contribue à l'obtention d'une répartition plus uniforme du rayonnement dans la tache de concentration produite ; et

- la fabrication du miroir primaire s'en trouve facilitée. Notamment, des dépôts uniformes peuvent être effectués plus facilement sur le miroir primaire, en disposant une source des matériaux déposés sensiblement au point de placement de la source de rayonnement par rapport à ce miroir primaire. Il n'est donc pas nécessaire de prévoir des gradients pour réaliser les dépôts sur le miroir primaire, qui lui confèrent son comportement réfléchissant. Le traitement du miroir primaire par des dépôts de matériaux peut alors être très efficace.

Ces avantages sont d'autant plus importants que la génératrice du miroir primaire correspond à l'équation (1) avec plus de précision. Ainsi, la bande du plan méridien qui contient la première génératrice peut être avantageusement plus étroite. En particulier, cette bande peut être réduite à [0,95 x R($\alpha$) ; 1,05 x R($\alpha$)], voire de préférence réduite à [0,98 x R($\alpha$) ; 1,02 x R($\alpha$)], ou encore mieux à [0,995 x R($\alpha$) ; 1,005 x R($\alpha$)],

De préférence, l'angle i peut être compris entre 20° et 60°, notamment pour limiter une longueur totale du collecteur parallèlement à son axe optique.

D'une façon générale, l'angle i peut être avantageusement fixé à une valeur distincte de celle de Brewster pour le miroir primaire et pour le rayonnement qui est produit par la source. Par exemple, l'angle i peut être situé en dehors de l'intervalle [35°; 45°]. Ainsi, un coefficient de réflexion peut être obtenu pour le miroir primaire, qui est plus élevé. Une quantité supérieure de rayonnement est alors envoyée dans la tache de concentration. Néanmoins, pour des applications particulières du rayonnement qui est collecté, la valeur de Brewster peut être choisie pour l'angle i.

La longueur $R_0$ peut être quelconque. Toutefois, des valeurs comprises entre 70 cm (centimètre) et 2 m (mètre) sont particulièrement adaptées par rapport aux sources DPP disponibles, ainsi que par rapport aux appareils existants d'utilisation du rayonnement collecté.

Le miroir secondaire peut être adapté pour que chaque point de celui-ci auquel est réfléchi un rayon de la partie collectée du rayonnement reçoive ce rayon avec un angle d'incidence qui est supérieur à 60°. Dans ces conditions, le coefficient de réflexion du miroir secondaire peut être élevé. Notamment il peut être supérieur à 50%.

La combinaison selon l'invention d'un miroir primaire qui est destiné à fonctionner avec une première valeur unique d'angle d'incidence des rayons sur ce miroir primaire, et qui est optimisé pour cette première valeur, avec un miroir secondaire qui est destiné à fonctionner avec des secondes valeurs élevées d'angle d'incidence sur ce miroir secondaire, aboutit à une efficacité globale de réflexion du collecteur qui est importante.

Grâce à la forme de la seconde génératrice du miroir secondaire, la partie qui est collectée du rayonnement produit par la source est concentrée dans une tache réduite à la sortie du collecteur.

En particulier, cette tache est encore plus petite lorsque chaque point de la seconde génératrice est situé dans le domaine [0,95 x X($\alpha$) ; 1,05 x X($\alpha$)] x [0,95 x Y($\alpha$) ; 1,05 x Y($\alpha$)], à l'intérieur du plan méridien. De façon encore plus préférée, chaque point de la seconde génératrice peut être situé dans le domaine [0,98 x X($\alpha$) ; 1,02 x X($\alpha$)] x [0,98 x Y($\alpha$) ; 1,02 x Y($\alpha$)] à l'intérieur du plan méridien, ou encore mieux dans le domaine [0,995 x X($\alpha$) ; 1,005 x X($\alpha$)] x [0,995 x Y($\alpha$) ; 1,005 x Y($\alpha$)] à l'intérieur de ce plan méridien.

De préférence, la distance f est comprise entre 10 cm et 2 m, voire entre 20 cm et 1,0 m, pour que le collecteur et la source DPP puissent être installés facilement sur un module d'utilisation du rayonnement au sein d'une ligne de production de circuits électroniques intégrés.

De préférence aussi, la longueur L est comprise entre 10 cm et 3 m.

Pour un perfectionnement de l'invention, le miroir secondaire présente une ouverture d'un côté qui est opposé au point de placement de la source du rayonnement. Dans ce cas, le collecteur peut comprendre en outre au moins un miroir supplémentaire à symétrie de révolution autour de l'axe optique du collecteur. Un tel miroir supplémentaire peut être disposé pour collecter une partie supplémentaire du rayonnement qui est produit par la source en la réfléchissant. Pour cela, il conjugue optiquement le point de placement de la source du rayonnement avec un point central de la tache de concentration de la partie du rayonnement qui est collectée par les miroirs primaire et secondaire. La partie supplémentaire du rayonnement qui est collectée par le miroir supplémentaire traverse alors l'ouverture du miroir secondaire, et est entourée par la partie du rayonnement qui est collectée par les miroirs primaire et secondaire, dans des plans perpendiculaires à l'axe optique du collecteur.

Le miroir supplémentaire du perfectionnement peut être un miroir ellipsoïdal unique.

Alternativement, le perfectionnement peut consister à ajouter deux miroirs supplémentaires au collecteur, par rapport aux miroirs primaire et secondaire. Ces deux miroirs supplémentaires peuvent être un miroir ellipsoïdal concave et un miroir hyperboloïdal convexe, qui sont disposés de sorte que la partie supplémentaire du rayonnement qui est collectée est réfléchie d'abord par le miroir ellipsoïdal puis par le miroir hyperboloïdal. En outre, le miroir ellipsoïdal et le miroir hyperboloïdal forment ensemble un doublet optique qui conjugue optiquement le point de placement de la source du rayonnement avec le point central de la tache de concentration du rayonnement collecté par les miroirs primaire et secondaire.

D'autres particularités et avantages de la présente invention apparaîtront dans la description ci-après d'exemples de réalisation non limitatifs, en référence aux dessins annexés, dans lesquels :

- la figure 1 illustre une mise en oeuvre d'un collecteur selon l'invention ;

- les figures 2a-2d sont des diagrammes de génératrices de miroirs, respectivement pour quatre collecteurs différents conformes à l'invention ; et

- la figure 3 illustre un perfectionnement d'un collecteur selon l'invention.

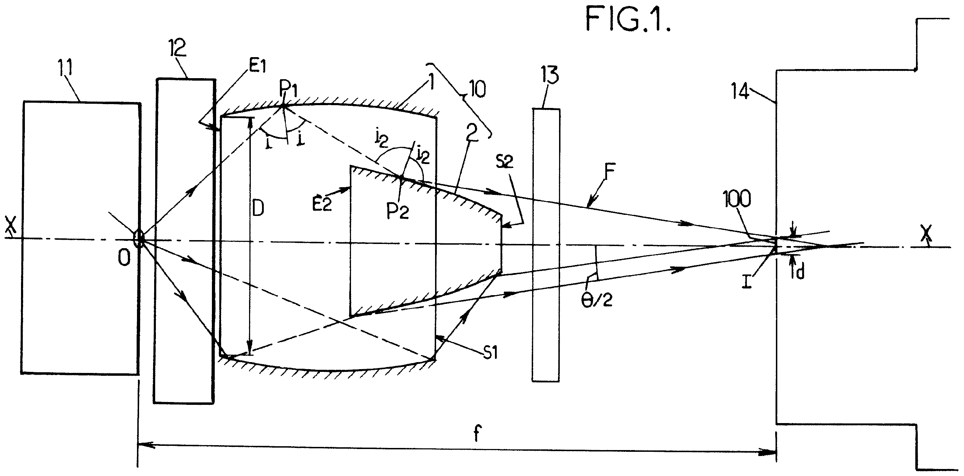

La figure 1 n'a qu'un but illustratif si bien que, pour la clarté de cette figure, les dimensions des différents éléments représentés ne correspondent ni à des dimensions ni à des rapports de dimensions réels.

Sur la Figure 1, un collecteur selon l'invention est référencé globalement 10. Il comprend un miroir primaire concave 1 et un miroir secondaire convexe 2. Les deux miroirs 1 et 2 possèdent chacun une symétrie de révolution autour d'un axe commun X-X, dit axe optique du collecteur 10. Dans la mise en oeuvre qui est représentée, les dispositifs suivants sont alignés le long de l'axe X-X, dans l'ordre : une source de rayonnement 11, un système de protection 12, le collecteur 10 lui-même, un filtre de rayonnement 13 et un appareil d'utilisation du rayonnement 14. La source 11 peut être du type DPP pour produire un rayonnement à 13,5 nm, et les autres dispositifs 10 et 12-14 sont adaptés pour fonctionner chacun optiquement à cette longueur d'onde. D'une façon qui est connue pour un utilisateur de source DPP, le système 12 peut être constitué à partir d'une roue à pales qui est mise en rotation rapide autour d'un axe parallèle à l'axe X-X. L'appareil 14 peut être un module de traitement lithographique, par exemple. Le filtre de rayonnement 13 est facultatif.

La source 11 produit le rayonnement à partir d'un volume de plasma 11a qui est petit, le plus souvent inférieur à 1 mm$^3$. Elle est disposée de façon à ce que ce volume de plasma soit superposé à un foyer O du collecteur 10. Dans ces conditions, le rayonnement qui est produit par la source 11 est concentré par le collecteur 10 dans un faisceau de sortie convergent, noté F. Ce faisceau F forme une tache de concentration du rayonnement qui est référencée 100, et qui correspond à l'endroit le long de l'axe X-X auquel le faisceau F possède une section transversale minimale. L'appareil 14 possède une fenêtre d'entrée optique, et il est disposé de sorte que la tache 100 soit située dans cette fenêtre.

Lorsque le miroir 1 possède une génératrice qui est conforme à l'équation (1) dans un plan méridien quelconque autour de l'axe X-X, un rayon qui est issu du foyer O se réfléchit sur le miroir 1 avec un angle d'incidence i qui est constant, quelque soit le point $P_1$ de la réflexion sur le miroir 1. Cette propriété remarquable du miroir 1 qui est introduite par l'invention, permet d'ajuster précisément un taux de réflexion du miroir 1 lorsqu'il est utilisé dans ces conditions. En effet, de façon générale, un coefficient de réflexion d'un miroir est ajusté par l'intermédiaire d'un ensemble de couches minces qui sont déposées sur sa surface. Or cet ensemble de couches est déterminé en fonction de la longueur d'onde du rayonnement et en fonction de l'angle d'incidence lors de la réflexion. La valeur constante de l'angle i le long de la surface du miroir 1 permet donc de déterminer et de réaliser un empilement de couches qui réalise le coefficient de réflexion voulu sur toute la surface du miroir 1. La conception et le mode de réalisation d'un tel empilement de couches est supposé connu de l'Homme du métier, et n'est pas repris ici. Par exemple, l'empilement de couches peut comprendre au moins quarante couches, qui sont alternativement à base de molybdène ou de silicium. Eventuellement, le miroir 1 peut être réalisé en plusieurs parties, en fonction de ses dimensions par rapport aux outils qui sont utilisés pour le fabriquer.

Un rayon qui est issu du volume de plasma 11a et qui est réfléchi par le miroir 1 est ensuite réfléchi par le miroir 2 en direction de la tache 100. On suppose que le miroir 2 possède une génératrice qui est conforme à l'équation (2) dans chaque plan méridien. L'angle d'incidence du rayonnement sur le miroir 2 n'est pas constant entre des points de ce miroir qui varient. Sur la figure, $P_2$ désigne le point du miroir 2 auquel est réfléchi un rayon qui provient du point $P_1$ sur le miroir 1, et $i_2$ désigne l'angle d'incidence correspondant au point $P_2$. Toutefois, l'angle d'incidence $i_2$ est supérieur à l'angle de Brewster quelque soit le point du miroir 2, et est proche de l'incidence rasante pour une grande partie du miroir. De cette façon, l'efficacité de réflexion du miroir 2 est élevée. Le miroir 2 est traité en surface d'une façon appropriée pour obtenir une telle réflexion. Notamment, il peut aussi comporter un empilement de couches qui est réfléchissant pour le rayonnement concerné. Eventuellement, le miroir 2 peut être constitué de plusieurs tranches successives le long de l'axe X-X, chacune en forme de couronne. Dans ce cas, l'empilement de couches peut être ajusté différemment pour chaque couronne, en fonction d'une valeur moyenne de l'angle d'incidence $i_2$ du rayonnement sur cette couronne.

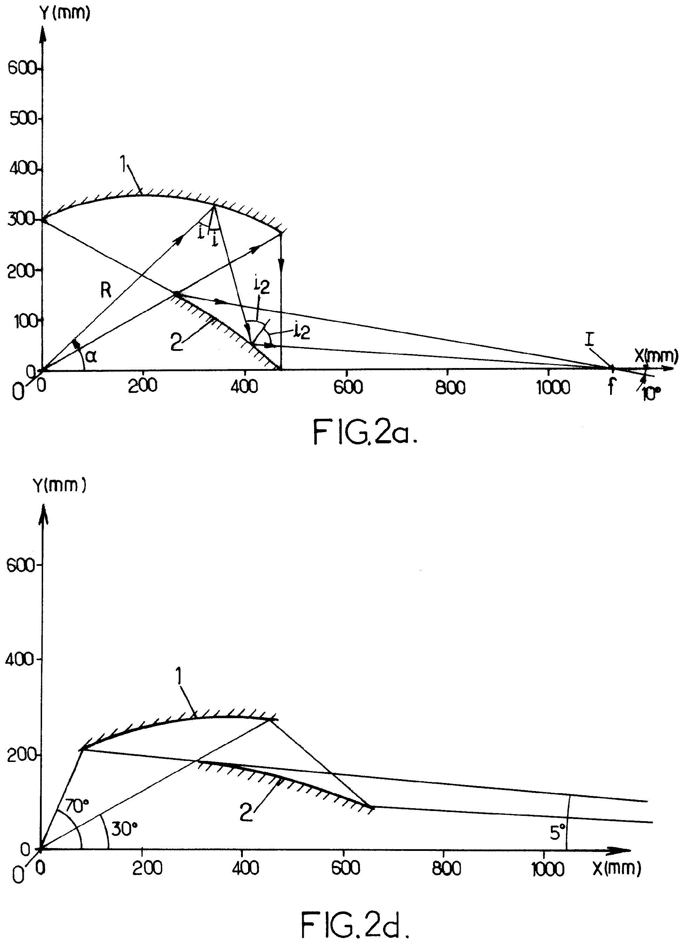

Les figures 2a-2d sont des graphes établis dans un plan méridien quelconque du collecteur 10, qui correspondent aux génératrices respectives des miroirs 1 et 2. L'axe des abscisses dans le plan méridien est l'axe optique X-X du collecteur, et l'axe des ordonnées Y est perpendiculaire à l'axe X-X. Les deux axes se coupent au foyer O du collecteur, qui est donc l'origine des coordonnées cartésiennes X et Y. Ils sont repérés chacun en millimètres (mm). La distance radiale R et l'angle $\alpha$, mesurés à partir du foyer O et de l'axe X-X, définissent des coordonnées polaires dans le plan méridien. Les génératrices respectives des miroirs 1 et 2 qui sont représentées sur ces graphes correspondent aux équations (1) et (2), pour les valeurs des paramètres i, $R_0$, f et L qui sont données dans le tableau 1 suivant :

Tableau 1

| | Miroir 1 | | Miroir 2 | |
|---|---|---|---|---|
| Figures | i (degrés) | $R_0$ (mm) | f (mm) | L (mm) |
| 2a | 30 | 743 | 1110 | 1464 |
| 2b | 40 | 747 | 1134 | 1352 |
| 2c | 50 | 910 | 1204 | 1361 |
| 2d | 52,5 | 1084 | 2445 | 2600 |

L est la longueur du trajet optique entre le foyer O et le point I auquel les rayons coupent l'axe X-X après avoir traversé le collecteur 10. Lorsque les miroirs 1 et 2 sont conformes aux équations (1) et (2), respectivement, le collecteur 10 est stigmatique entre les points O et I. Dans ce cas, la longueur L du trajet optique entre le foyer O et le point I est constante, au moins au premier ordre, pour des rayons différents qui sont réfléchis par les deux miroirs à l'intérieur plan méridien. Toutefois, il n'est pas nécessaire que le collecteur soit stigmatique. Il produit alors, à partir du rayonnement collecté qui est issu du foyer O, une tache de concentration de ce rayonnement qui présente un diamètre minimal non nul à un endroit donné sur l'axe X-X. La figure 1 illustre une telle configuration astigmatique du collecteur 10. La référence 100 désigne la tache de concentration du rayonnement collecté, et d désigne son diamètre. La tache de concentration de la partie du rayonnement qui est collectée, présente avantageusement un diamètre inférieur à 7 mm, de préférence inférieur à 5 mm, perpendiculairement à l'axe X-X. Une telle dimension de la tache de concentration est adaptée pour de nombreux appareils d'utilisation du rayonnement 14.

La longueur de chaque miroir 1, 2, parallèlement à l'axe X-X, peut varier en fonction des critères suivants, dont la liste n'est pas exhaustive :

- l'ouverture d'entrée $E_1$ du miroir 1, du côté du foyer O, peut être située dans un plan perpendiculaire à l'axe X-X qui est décalé vers la sortie du collecteur 10, d'une façon qui est adaptée en fonction de l'encombrement du système de protection 12 qui est utilisé ;

- l'ouverture de sortie $S_1$ du miroir 1, du côté opposé au foyer O, et l'ouverture $E_2$ du miroir 2 qui est du côté du foyer O, peuvent être déterminées en fonction d'occultations réciproques que chacune de ces ouvertures pourraient provoquer sur un bord de l'autre miroir ; et

- l'ouverture $S_2$ du miroir 2 du côté de la sortie du collecteur peut être fixée en suivant un rayon qui se réfléchit sur le bord du miroir 1, aussi du côté de la sortie du collecteur.

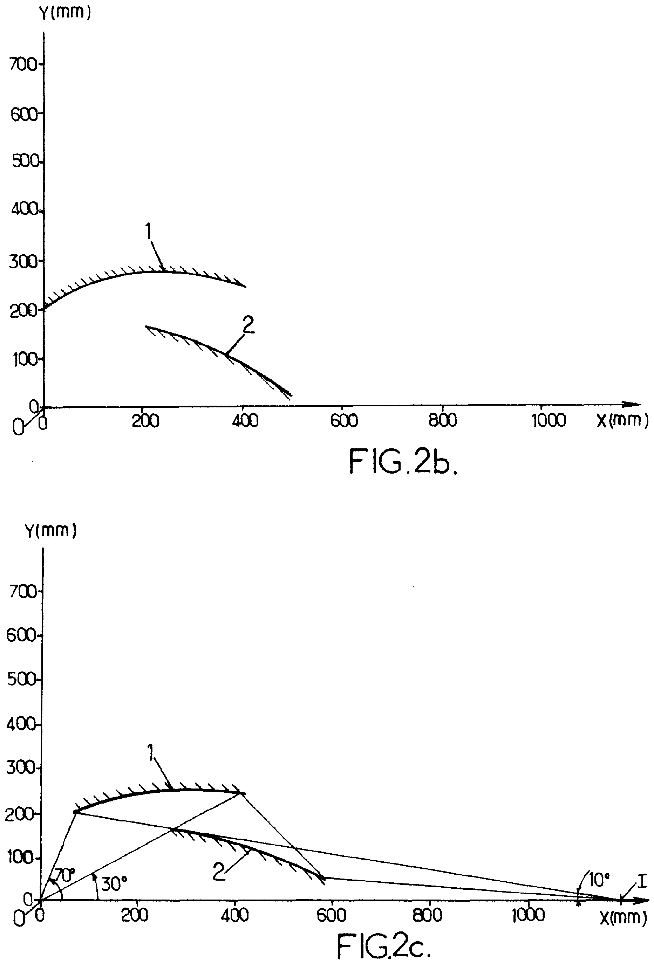

Par exemple, l'ouverture $E_1$ du miroir 1 est située dans un plan qui passe par le foyer O pour les collecteurs des figures 2a et 2b. Pour les collecteurs des figures 2c et 2d, elle correspond à une valeur de 70° (degrés) de l'angle polaire $\alpha$.

De préférence, l'ouverture d'entrée $E_1$ du miroir primaire 1, du côté du point de placement de la source du rayonnement, c'est-à-dire du côté du foyer O, possède un diamètre D qui est supérieur à 200 mm (Figure 1). Une telle section d'entrée du rayonnement dans le collecteur 10 contribue à obtenir un taux de collecte du rayonnement produit par la source qui est élevé.

L'ouverture $S_1$ du miroir 1 du côté de la sortie du collecteur, pour les collecteurs des figures 2c et 2d correspond à une valeur de 30° de l'angle polaire α.

L'ouverture $S_2$ du miroir 2 du côté de la sortie du collecteur peut être fixée en fonction de l'encombrement du filtre 13, par rapport à la distance qui sépare le miroir 2 et le point I. Eventuellement, le miroir 2 peut être fermé sous la forme d'une pointe du côté de la sortie du collecteur, lorsqu'il se prolonge jusqu'à l'axe X-X (Figure 2a).

Avantageusement, le faisceau F de sortie du collecteur, qui est convergent et forme la tache de concentration 100, peut posséder un demi-angle d'ouverture θ/2 qui est inférieur à 15°, de préférence inférieur à 10°. A titre d'exemples, le demi-angle θ/2 est égal à 10° pour les collecteurs des Figures 2a et 2c, et égal à 5° pour le collecteur de la figure 2d. De telles valeurs du demi-angle θ/2 sont adaptées à de nombreux appareils 14, et compatibles avec l'utilisation du filtre 13 entre le collecteur 10 et l'appareil 14.

En utilisant un collecteur selon l'invention, à deux miroirs comme décrit jusqu'à présent, le rayonnement qui provient du foyer O et qui est concentré dans la tache 100 peut correspondre à une proportion qui est supérieure à 20%, voire de l'ordre de 25%, du rayonnement total qui est issu du foyer O, en termes d'intensité. Autrement dit, le taux de collecte du rayonnement est supérieur à 20 %, voire à 25 %.

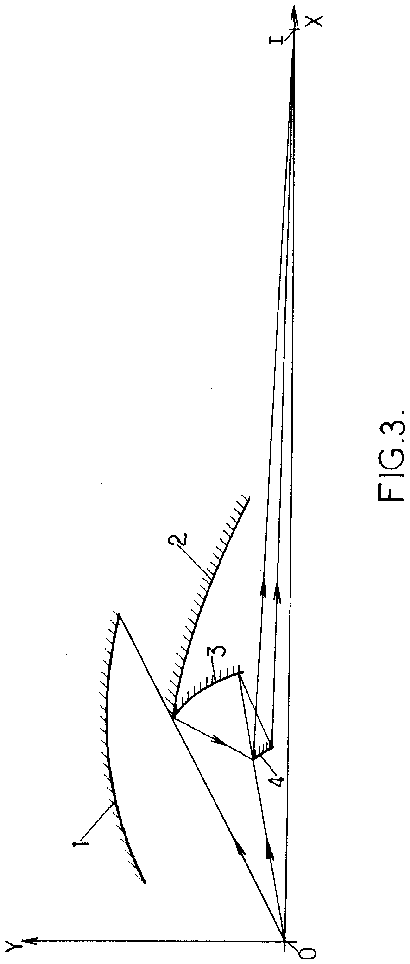

On décrit maintenant un perfectionnement de l'invention qui permet d'augmenter d'environ 5% la proportion du rayonnement collecté. Conformément à la Figure 3, deux miroirs supplémentaires 3 et 4 peuvent être ajoutés, en plus des miroirs 1 et 2. Les deux miroirs supplémentaires 3 et 4 sont chacun à symétrie de révolution autour de l'axe optique X-X du collecteur.

Le miroir 3 est ellipsoïdal concave et le miroir 4 est hyperboloïdal convexe. Ils sont disposés de façon à collecter une partie supplémentaire du rayonnement qui est produit par la source au foyer O, en réfléchissant cette partie supplémentaire du rayonnement d'abord sur le miroir 3 puis sur le miroir 4. En outre, ils forment un doublet qui conjugue optiquement le foyer O et le centre I de la tache 100 de concentration de la partie du rayonnement qui est collectée par les miroirs 1 et 2. La Figure 3 n'est donnée qu'à titre d'illustration du principe de ce perfectionnement, et l'Homme du métier saura, à partir de ce principe, déterminer les caractéristiques géométriques des miroirs 3 et 4.

Pour mettre en oeuvre ce perfectionnement, le miroir secondaire 2 doit être ouvert du côté de la sortie du collecteur, opposé au foyer O. La partie supplémentaire du rayonnement qui est collectée par les miroirs 3 et 4 traverse alors cette ouverture, et est entourée par la partie du rayonnement qui est collectée par les miroirs 1 et 2, dans des plans perpendiculaires à l'axe X-X.

Dans tous les modes de réalisation d'un collecteur conforme à l'invention qui viennent d'être décrits, le miroir 1 peut posséder en outre une fonction de suppression d'une partie du rayonnement qui est produit par la source, et qui ne serait pas désirée dans la tache de concentration 100. Pour cela, le miroir 1 peut être absorbant pour un rayonnement qui possède une longueur d'onde plus grande que celle de la partie collectée du rayonnement qui est concentrée dans la tache 100. Dans ce cas, le collecteur peut comprendre en outre un système de refroidissement qui est agencé pour refroidir le miroir 1, afin d'évacuer l'énergie du rayonnement qui est absorbé par ce miroir.

## Revendications

1. Collecteur de rayonnement (10), adapté pour collecter une partie d'un rayonnement produit par une source et pour concentrer ladite partie collectée du rayonnement dans une tache (100) formée par un faisceau de sortie convergent (F) produit par ledit collecteur,
   ledit collecteur comprenant un miroir primaire (1) et un miroir secondaire (2), chacun à symétrie de révolution autour d'un axe optique (X-X) du collecteur, et disposés pour réfléchir la partie collectée du rayonnement d'abord par ledit miroir primaire puis par ledit miroir secondaire,
   le miroir primaire (1) étant concave et ayant une première génératrice dans un plan méridien du dispositif contenant l'axe optique du collecteur, située dans la bande [0,8 x R(α) ; 1,2 x R(α)], R et α étant des coordonnées polaires à l'intérieur du plan méridien, R étant une coordonnée radiale mesurée à partir d'un point (O) de l'axe optique (X-X) auquel la source du rayonnement est destinée à être placée et α étant une coordonnée angulaire mesurée à partir dudit axe optique, et R(α) étant calculée selon l'équation (1) suivante :

$$R(\alpha) = R_0 \cdot exp[-\alpha \cdot tan(i)] \qquad (1)$$

   où α est exprimée en radians, $R_0$ est une longueur constante, et i est un angle constant différent de +/-90°, et
   le miroir secondaire (2) ayant une seconde génératrice dans ledit plan méridien, adaptée pour que ledit miroir secondaire produise le faisceau de sortie convergent (F) d'un côté du collecteur opposé à la source du rayonnement, à partir de la partie collectée du rayonnement réfléchie par le miroir primaire (1), la seconde génératrice du miroir secondaire (2) étant constituée de points ($P_2$) ayant des coordonnées cartésiennes X et Y à l'intérieur du plan méridien, l'origine des dites coordonnées cartésiennes étant le point (O) de placement de la source du rayonnement et X correspondant à l'axe optique du collecteur,

chaque point de la seconde génératrice étant situé dans le domaine [0,8 x X($\alpha$) ; 1,2 x X($\alpha$)] x [0,8 x Y($\alpha$) ; 1,2 x Y($\alpha$)], X($\alpha$) et Y($\alpha$) étant calculées selon les équations (2) et (3) suivantes :

$$X(\alpha) = \frac{2 \cdot R(\alpha) \cdot cos(\alpha) \cdot [L - R(\alpha) \cdot (1 + cos(2i))] + (f^2 - L^2 + 2 \cdot L \cdot R(\alpha)) \cdot cos(\alpha)}{2[L - R(\alpha) \cdot (1 + cos(2i)) + f \cdot cos(\alpha)]} \quad (2)$$

$$Y(\alpha) = R(\alpha) \cdot sin(\alpha) + [X(\alpha) - R(\alpha) \cdot cos(\alpha)] \cdot tan(\alpha + 2 \cdot i) \quad (3)$$

où $\alpha$ est la coordonnée polaire angulaire de l'équation (1) utilisée pour paramétrer les coordonnées cartésiennes de la seconde génératrice, R($\alpha$) est calculée selon l'équation (1),

f est la distance entre le point de placement de la source du rayonnement (O) et la tache (100) de concentration de la partie collectée du rayonnement, mesurée le long de l'axe optique (X-X), et

L est la longueur d'un chemin optique entre le point de placement de la source du rayonnement (O) et la tache (100) de concentration de la partie collectée du rayonnement, mesurée le long d'un rayon issu dudit point de placement de la source du rayonnement et réfléchi par le miroir primaire (1) puis par le miroir secondaire (2).

2. Collecteur selon la revendication 1, dans lequel l'angle i est compris entre 20° et 60°.

3. Collecteur selon la revendication 1 ou 2, dans lequel l'angle i est situé en dehors de l'intervalle [35° ; 45°].

4. Collecteur selon l'une quelconque des revendications précédentes, dans lequel la première génératrice du miroir primaire (1) est située en outre dans la bande [0,95 x R($\alpha$) ; 1,05 x R($\alpha$)], à l'intérieur du plan méridien.

5. Collecteur selon l'une quelconque des revendications précédentes, dans lequel le miroir primaire (1) possède une ouverture d'entrée ($E_1$), du côté du point de placement de la source du rayonnement (O), avec un diamètre (D) supérieur à 200 mm pour ladite ouverture.

6. Collecteur selon l'une quelconque des revendications précédentes, dans lequel le miroir secondaire (2) est adapté pour que chaque point dudit miroir secondaire réfléchissant un rayon de la partie collectée du rayonnement reçoive ledit rayon avec un angle d'incidence ($i_2$) supérieur à 60°.

7. Collecteur selon l'une quelconque des revendications précédentes, dans lequel chaque point ($P_2$) de la seconde génératrice est situé dans le domaine [0,95 x X($\alpha$) ; 1,05 x X($\alpha$)] x [0,95 x Y($\alpha$) ; 1,05 x Y($\alpha$)], à l'intérieur du plan méridien.

8. Collecteur selon l'une quelconque des revendications précédentes, adapté en outre de sorte que la tache de concentration (100) de la partie collectée du rayonnement, présente un diamètre (d) inférieur à 7 mm, de préférence inférieur à 5 mm, perpendiculairement à l'axe optique (X-X).

9. Collecteur selon l'une quelconque des revendications précédentes, adapté en outre de sorte que le faisceau de sortie convergent (F), qui forme la tache de concentration (100) de la partie collectée du rayonnement, ait un demi angle d'ouverture ($\theta/2$) inférieur à 15°, de préférence inférieur à 10°.

10. Collecteur selon l'une quelconque des revendications précédentes, dans lequel les miroirs primaire (1) et secondaire (2) sont adaptés pour réfléchir un rayonnement ultraviolet extrême produit par la source.

11. Collecteur selon la revendication 10, dans lequel les miroirs primaire (1) et secondaire (2) sont adaptés pour réfléchir un rayonnement produit par la source, ayant une longueur d'onde égale à 13,5 nm.

12. Collecteur selon l'une quelconque des revendications précédentes, dans lequel le miroir primaire (1) est absorbant pour une autre partie du rayonnement produit par la source, avec une longueur d'onde plus grande qu'une longueur d'onde de la partie collectée du rayonnement qui est concentrée dans la tache (100) formée par le faisceau de sortie convergent (F), et

ledit collecteur comprenant en outre un système de refroidissement agencé pour refroidir le miroir primaire.

13. Collecteur selon l'une quelconque des revendications précédentes, dans lequel le miroir secondaire (2) présente une ouverture ($S_2$) d'un côté opposé au point de placement de la source de rayonnement (O), et

ledit collecteur comprenant en outre au moins un miroir supplémentaire, à symétrie de révolution autour de l'axe optique (X-X) du collecteur, disposé pour collecter une partie supplémentaire du rayonnement produit par la source en réfléchissant ladite partie supplémentaire du rayonnement, et pour conjuguer optiquement le point de placement de la source du rayonnement (O) avec un point central (I) de la tache de concentration de la partie du rayonnement collectée par les miroirs primaire (1) et secondaire (2),

ledit miroir supplémentaire étant disposé en outre de sorte que ladite partie supplémentaire du rayonnement qui est collectée traverse l'ouverture dudit miroir secondaire ($S_2$), et est entourée par la partie du rayonnement qui est collectée par les miroirs primaire (1) et secondaire (2), dans des plans perpendiculaires à l'axe optique du collecteur (X-X).

14. Collecteur selon la revendication 13, dans lequel ledit au moins un miroir supplémentaire comprend un miroir ellipsoïdal concave (3) et un miroir hyperboloïdal convexe (4), chacun à symétrie de révolution autour de l'axe optique du collecteur (X-X), disposés pour collecter la partie supplémentaire du rayonnement produit par la source en réfléchissant ladite partie supplémentaire du rayonnement d'abord sur le miroir ellipsoïdal puis sur le miroir hyperboloïdal.

**Patentansprüche**

1. Strahlungskollektor (10), der angepasst ist, einen Teil einer durch eine Quelle erzeugten Strahlung zu sammeln und den gesammelten Teil der Strahlung in einem Fleck (100), der durch einen vom Kollektor erzeugten konvergierenden Austrittsstrahl (F) ausgebildet wird, zu konzentrieren,

wobei der Kollektor einen Primärspiegel (1) und einen Sekundärspiegel (2) umfasst, die jeweils um eine optische Achse (X-X) des Kollektors rotationssymmetrisch sind und die so angeordnet sind, dass der gesammelte Teil der Strahlung zunächst vom Primärspiegel und anschließend vom Sekundärspiegel reflektiert wird,

wobei der Primärspiegel (1) konkav ist und in einer die optische Achse des Kollektors beinhaltenden Meridianebene der Vorrichtung eine erste Erzeugende aufweist, die im Band [0,8 x R($\alpha$); 1,2 x R($\alpha$)] angeordnet ist, wobei R und $\alpha$ Polarkoordinaten innerhalb der Meridianebene sind, R eine Radialkoordinate ist, die von einem Punkt (0) der optischen Achse (X-X) gemessen wird, an dem die Strahlungsquelle angeordnet werden soll, und $\alpha$ eine Winkelkoordinate ist, die von der optischen Achse gemessen wird, und wobei R($\alpha$) anhand folgender Gleichung (1) berechnet wird:

$$R(\alpha) = R_0 \cdot exp[-\alpha \cdot tan(i)] \tag{1}$$

wobei $\alpha$ in rad ausgedrückt ist, $R_0$ eine konstante Länge ist und i ein konstanter Winkel ungleich +/-90° ist, und

wobei der Sekundärspiegel (2) eine zweite Erzeugende in der Meridianebene aufweist, die so angepasst ist, dass der Sekundärspiegel den konvergierenden Austrittsstrahl (F) auf einer der Strahlungsquelle gegenüberliegenden Seite des Kollektors anhand des gesammelten, vom Primärspiegel (1) reflektierten Teils der Strahlung erzeugt, wobei die zweite Erzeugende des Sekundärspiegels (2) aus Punkten ($P_2$) gebildet ist, die kartesische Koordinaten X und Y innerhalb der Meridianebene aufweisen, wobei der Ursprung der kartesischen Koordinaten der Punkt (0) der Strahlungsquellenanordnung ist und X der optischen Achse des Kollektors entspricht,

wobei sich jeder Punkt der zweiten Erzeugenden im Bereich [0,8 x X($\alpha$); 1,2 x X($\alpha$)] x [0,8 x Y($\alpha$); 1,2 x Y($\alpha$)] befindet, wobei X($\alpha$) und Y($\alpha$) nach den folgenden Gleichungen (2) und (3) berechnet werden:

$$X(\alpha) = \frac{2 \cdot R(\alpha) \cdot cos(\alpha) \cdot [L - R(\alpha) \cdot (1 + cos(2i))] + (f^2 - L^2 + 2 \cdot L \cdot R(\alpha)) \cdot cos(\alpha)}{2[L - R(\alpha) \cdot (1 + cos(2i)) + f \cdot cos(\alpha)]} \tag{2}$$

$$Y(\alpha) = R(\alpha) \cdot sin(\alpha) + \left[ X(\alpha) - R(\alpha) \cdot cos(\alpha) \right] \cdot tan(\alpha + 2 \cdot i) \tag{3}$$

wobei $\alpha$ die Polarwinkelkoordinate der Gleichung (1) ist, die verwendet wird, um die kartesischen Koordinaten der zweiten Erzeugenden zu parametrieren, wobei $R(\alpha)$ nach der Gleichung (1) berechnet wird,
wobei f der Abstand zwischen dem Strahlungsquellenanordnungspunkt (0) und dem Fleck (100) der Konzentration des gesammelten Teils der Strahlung, gemessen entlang der optischen Achse (X-X), ist und
wobei L die Länge eines optischen Wegs zwischen dem Strahlungsquellenanordnungspunkt (0) und dem Fleck (100) der Konzentration des gesammelten Teils der Strahlung, gemessen entlang eines vom Strahlungsquellenanordnungspunkt ausgehenden und vom Primärspiegel (1) und anschließend vom Sekundärspiegel (2) reflektierten Strahls, ist.

2. Kollektor nach Anspruch 1, wobei der Winkel i 20° bis 60° beträgt.

3. Kollektor nach Anspruch 1 oder 2, wobei sich der Winkel i außerhalb des Intervalls [35°; 45°] befindet.

4. Kollektor nach einem der vorangehenden Ansprüche, wobei sich die erste Erzeugende des Primärspiegels (1) ferner im Band [0,95 x $R(\alpha)$; 1,05 x $R(\alpha)$] innerhalb der Meridianebene befindet.

5. Kollektor nach einem der vorangehenden Ansprüche, wobei der Primärspiegel (1) auf der Seite des Strahlungsquellenanordnungspunkts (0) eine Eintrittsöffnung ($E_1$) besitzt, wobei ein Durchmesser (D) für die Öffnung größer als 200 mm ist.

6. Kollektor nach einem der vorangehenden Ansprüche, wobei der Sekundärspiegel (2) so angepasst ist, dass jeder Punkt des Sekundärspiegels, der einen Strahl des gesammelten Teils der Strahlung reflektiert, den Strahl mit einem Einfallswinkel ($i_2$) von über 60° empfängt.

7. Kollektor nach einem der vorangehenden Ansprüche, wobei sich jeder Punkt ($P_2$) der zweiten Erzeugenden im Bereich [0,95 x $X(\alpha)$; 1,05 x $X(\alpha)$] x [0,95 x $Y(\alpha)$; 1,05 x $Y(\alpha)$] innerhalb der Meridianebene befindet.

8. Kollektor nach einem der vorangehenden Ansprüche, der ferner so angepasst, dass der Konzentrationsfleck (100) des gesammelten Teils der Strahlung einen Durchmesser (d) von weniger als 7 mm, vorzugsweise weniger als 5 mm, senkrecht zur optischen Achse (X-X) aufweist.

9. Kollektor nach einem der vorangehenden Ansprüche, der ferner so angepasst ist, dass der konvergierende Austrittsstrahl (F), der den Konzentrationsfleck (100) des gesammelten Teils der Strahlung ausbildet, einen halben Öffnungswinkel ($\Theta/2$) von weniger als 15°, vorzugsweise weniger als 10°, aufweist.

10. Kollektor nach einem der vorangehenden Ansprüche, wobei der Primärspiegel (1) und der Sekundärspiegel (2) angepasst sind, eine von der Quelle erzeugte extreme ultraviolette Strahlung zu reflektieren.

11. Kollektor nach Anspruch 10, wobei der Primärspiegel (1) und der Sekundärspiegel (2) angepasst sind, eine von der Quelle erzeugte Strahlung mit einer Wellenlänge von 13,5 nm zu reflektieren.

12. Kollektor nach einem der vorangehenden Ansprüche, wobei der Primärspiegel (1) für einen anderen Teil der von der Quelle erzeugten Strahlung mit einer größeren Wellenlänge als einer Wellenlänge des gesammelten Teils der Strahlung, der in dem vom konvergierenden Austrittsstrahl (F) ausgebildeten Fleck konzentriert wird, absorbierend ist,
und
wobei der Kollektor ferner ein Kühlsystem umfasst, das eingerichtet ist, um den Primärspiegel zu kühlen.

13. Kollektor nach einem der vorangehenden Ansprüche, wobei der Sekundärspiegel (2) eine Öffnung ($S_2$) auf einer dem Strahlungsquellenanordnungspunkt (0) gegenüberliegenden Seite aufweist und
wobei der Kollektor ferner zumindest einen zusätzlichen Spiegel, der um die optische Achse (X-X) des Kollektors rotationssymmetrisch ist und der angeordnet ist, um einen zusätzlichen Teil der von der Quelle erzeugten Strahlung zu sammeln, indem er den zusätzlichen Teil der Strahlung reflektiert, und um den Strahlungsquellenanordnungspunkt (0) mit einem Mittelpunkt (I) des Konzentrationsflecks des von dem Primärspiegel (1) und dem Sekundärspiegel (2) gesammelten Teils der Strahlung optisch zu verbinden, wobei der zusätzliche Spiegel ferner so angeordnet ist, dass der gesammelte zusätzliche Teil der Strahlung die Öffnung des Sekundärspiegels ($S_2$) passiert und von dem Teil der Strahlung, der vom Primärspiegel (1) und vom Sekundärspiegel (2) gesammelt wird, in zur optischen Achse des Kollektors (X-X) senkrechten Ebenen umgeben ist.

14. Kollektor nach Anspruch 13, wobei der zumindest eine zusätzliche Spiegel einen konkaven elliptischen Spiegel (3) und einen konvexen hyperbolischen Spiegel (4) umfasst, die jeweils um die optische Achse des Kollektors (X-X) rotationssymmetrisch sind und die angeordnet sind, um den zusätzlichen Teil der von der Quelle erzeugten Strahlung zu sammeln, indem sie den zusätzlichen Teil der Strahlung zunächst auf den elliptischen Spiegel und anschließend auf den hyperbolischen Spiegel reflektieren.

## Claims

1. Radiation collector (10), adapted to collect a portion of a radiation produced by a source and to concentrate said collected portion of the radiation in a spot (100) formed by a convergent output beam (F) produced by said collector, said collector comprising a primary mirror (1) and a secondary mirror (2), each being rotationally symmetrical about an optical axis (X-X) of the collector, and arranged to reflect the collected portion of the radiation firstly by said primary mirror and then by said secondary mirror,

the primary mirror (1) being concave and having a first generatrix in a meridian plane of the device containing the optical axis of the collector, located in the domain [0.8 x R($\alpha$); 1.2 x R($\alpha$)], R and $\alpha$ being polar coordinates within the meridian plane, R being a radial coordinate measured from a point (O) of the optical axis (X-X) at which the source of radiation is intended to be placed and $\alpha$ being an angular coordinate measured from said optical axis, and R($\alpha$) being calculated according to the following equation (1):

$$R(\alpha) = R_0 \cdot exp[-\alpha \cdot tan(i)] \qquad (1)$$

where $\alpha$ is expressed in radians, $R_0$ is a constant length, and i is a constant angle not equal to +/-90°, and

the secondary mirror (2) having a second generatrix in said meridian plane, adapted so that said secondary mirror produces the convergent output beam (F) on a side of the collector opposite to the source of radiation, from the collected portion of the radiation reflected by the primary mirror (1), the second generatrix of the secondary mirror (2) being constituted by points ($P_2$) having Cartesian coordinates X and Y within the meridian plane, the origin of said Cartesian coordinates being the point (O) of placement of the radiation source and X corresponding to the optical axis of the collector,

each point of the second generatrix being located in the domain [0.8 x X($\alpha$); 1.2 x X($\alpha$)] x [0.8 x Y($\alpha$); 1.2 x Y($\alpha$)], X($\alpha$) and Y($\alpha$) being calculated according to the following equations (2) and (3):

$$X(\alpha) = \frac{2 \cdot R(\alpha) \cdot cos(\alpha) \cdot [L - R(\alpha) \cdot (1 + cos(2i))] + (f^2 - L^2 + 2 \cdot L \cdot R(\alpha)) \cdot cos(\alpha)}{2[L - R(\alpha) \cdot (1 + cos(2i)) + f \cdot cos(\alpha)]} \qquad (2)$$

$$Y(\alpha) = R(\alpha) \cdot sin(\alpha) + [X(\alpha) - R(\alpha) \cdot cos(\alpha)] \cdot tan(\alpha + 2 \cdot i) \qquad (3)$$

where $\alpha$ is the angular polar coordinate of equation (1) used for parametrization of the Cartesian coordinates of the second generatrix, R($\alpha$) is calculated according to equation (1),

f is the distance between the point of placement of the radiation source (O) and the concentration spot (100) of the collected portion of the radiation, measured along the optical axis (X-X), and

L is the length of an optical path between the point of placement of the radiation source (O) and the concentration spot (100) of the collected portion of the radiation, measured along a ray originating from said point of placement of the radiation source and reflected by the primary mirror (1) and then by the secondary mirror (2).

2. Collector according to claim 1, in which angle i is between 20° and 60°.

3. Collector according to claim 1 or 2, in which angle i is outside of the range [35°; 45°].

**4.** Collector according to any one of the preceding claims, in which the first generatrix of the primary mirror (1) is moreover located in the domain $[0.95 \times R(\alpha); 1.05 \times R(\alpha)]$, within the meridian plane.

**5.** Collector according to any one of the preceding claims, in which the primary mirror (1) has an entry aperture ($E_1$) on the same side as the point of placement of the radiation source (O), with a diameter (D) greater than 200 mm for said aperture.

**6.** Collector according to any one of the preceding claims, in which the secondary mirror (2) is adapted so that each point of said secondary mirror reflecting a ray of the collected portion of the radiation receives said ray with an angle of incidence ($i_2$) greater than 60°.

**7.** Collector according to any one of the preceding claims, in which each point ($P_2$) of the second generatrix is in the domain $[0.95 \times X(\alpha); 1.05 \times X(\alpha)] \times [0.95 \times Y(\alpha); 1.05 \times Y(\alpha)]$, within the meridian plane.

**8.** Collector according to any one of the preceding claims, adapted moreover so that the concentration spot (100) of the collected portion of the radiation has a diameter (d) less than 7 mm, preferably less than 5 mm, perpendicularly to the optical axis (X-X).

**9.** Collector according to any one of the preceding claims, adapted moreover so that the convergent output beam (F), which forms the concentration spot (100) of the collected portion of the radiation, has a cone semi-angle ($\theta/2$) less than 15°, preferably less than 10°.

**10.** Collector according to any one of the preceding claims, in which the primary (1) and secondary (2) mirrors are adapted to reflect extreme ultraviolet radiation produced by the source.

**11.** Collector according to claim 10, in which the primary (1) and secondary (2) mirrors are adapted to reflect radiation produced by the source having a wavelength equal to 13.5 nm.

**12.** Collector according to any one of the preceding claims, in which the primary mirror (1) is absorbing for another portion of the radiation produced by the source, with a wavelength greater than a wavelength of the collected portion of the radiation that is concentrated on the spot (100) formed by the convergent output beam (F), and said collector comprising moreover a cooling system arranged for cooling the primary mirror.

**13.** Collector according to any one of the preceding claims, in which the secondary mirror (2) has an aperture ($S_2$) on a side opposite to the point of placement of the radiation source (O), and said collector comprising moreover at least one additional mirror, rotationally symmetrical about the optical axis (X-X) of the collector, arranged for collecting an additional portion of the radiation produced by the source by reflecting said additional portion of radiation, and for optically conjugating the point of placement of the radiation source (O) with a central point (I) of the concentration spot of the portion of the radiation collected by the primary (1) and secondary (2) mirrors, said additional mirror being arranged moreover so that said additional portion of the radiation that is collected passes through the aperture of said secondary mirror ($S_2$), and is surrounded by the portion of the radiation that is collected by the primary (1) and secondary (2) mirrors, in planes perpendicular to the optical axis of the collector (X-X).

**14.** Collector according to claim 13, in which said at least one additional mirror comprises a concave ellipsoidal mirror (3) and a convex hyperboloidal mirror (4), each being rotationally symmetrical about the optical axis of the collector (X-X), arranged for collecting the additional portion of the radiation produced by the source by reflecting said additional portion of radiation firstly on the ellipsoidal mirror and then on the hyperboloidal mirror.

FIG.1.

FIG.2a.

FIG.2d.

FIG.2b.

FIG.2c.

FIG.3.

EP 2 286 294 B1

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 2819404 A

- FR 2579752